# EUROPÄISCHE PATENTANMELDUNG

(11) **EP 1 342 760 A1**
(43) Veröffentlichungstag der Anmeldung: **10.09.2003**
(21) Anmeldenummer: 03001518.4
(22) Anmeldetag: 23.01.2003
(51) Int. Cl.: C09D 11/10, H01C 17/065, H01L 23/498, H01L 23/532, H05K 1/09

(54) **Wasserlösliche Paste und deren Verwendung**

(30) Priorität: 06.03.2002 DE 10209835
(71) Anmelder: ROBERT BOSCH GMBH, 70442 Stuttgart (DE)
(72) Erfinder: Kuschel, Petra, 71229 Leonberg-Hoefingen (DE); Winkler, Matthias, 74196 Neuenstadt (DE); Renger, Christoph, 70178 Stuttgart (DE); Hirth, Erhard, 74249 Ellhofen (DE); Kristoffersson, Annika, 70999 Stuttgart (DE)

(57) **Zusammenfassung**

Es wird eine umweltfreundliche, wasserlösliche Paste vorgeschlagen, die insbesondere als Druckpaste geeignet ist. Die Paste weist ein Lösungsmittel, einen Binder und einen Füllstoff auf, wobei der Binder biologisch abbaubar ist, und wobei der Füllstoff ein keramischer Füllstoff, ein metallischer Füllstoff oder eine Mischung aus einem keramischen und einem metallischen Füllstoff ist.

## Beschreibung

Die Erfindung betrifft eine wasserlösliche Paste, insbesondere eine Druckpaste, sowie deren Verwendung nach der Gattung des Hauptanspruches.

### Stand der Technik

In pastösen Systemen für Anwendungen in der industriellen Drucktechnik werden üblicherweise organische, hoch siedende Lösungsmittel sowie Weichmacher eingesetzt, die bei der Herstellung, Trocknung und Reinigung der Maschinen, mit denen diese Pasten verarbeitet wurden, eine Gefährdung des Bedieners bzw. der Umwelt darstellen können. Insbesondere sind viele Bestandteile wie Phthalate gesundheitsgefährdend oder sogar fruchtschädigend, so dass bei Umgang mit diesen Stoffen sehr vorsichtig gearbeitet werden muss, um Kontaminationen zu vermeiden.

In der Dickschichttechnik zum Aufbau von Keramischen Sensoren bzw. allgemeiner der Siebdrucktechnik werden vielfach Pasten mit Füllstoffen bzw. Pigmenten, Lösungsmitteln, Bindern, Weichmachern und Dispergatoren verwendet, wobei die Trägerphase oder Matrixphase aus Lösungsmittel, Binder, Weichmacher und Dispergator auf das jeweilige Pigment, d. h. ein eingesetztes Keramikpulver oder Metallpulver, abgestimmt ist.

Das Lösungsmittel, das bevorzugt einen geringen Dampfdruck aufweist, ist dabei ein temporäres Vehikel, das eine zuverlässige Verarbeitbarkeit der Paste gewährleistet, so dass diese während des Verarbeitungsprozesses keinen physikalischen und chemischen Veränderungen unterliegt.

Im Stand der Technik wird bisher vor allem Diethylenglycolmonobutylether als Lösungsmittel eingesetzt, das den Binder, der für die gewünschte Verarbeitungskonsistenz und den Zusammenhalt der Paste nach Entfernen des Lösungsmittels über einen thermischen Prozess verantwortlich ist, auflöst.

Die Aufgabe des Weichmachers liegt vor allem darin, die Flexibilität einer aus der Paste durch Trocknen hergestellten Schicht zu gewährleisten.

Der Dispergator verhindert das Absetzen der zugesetzten Pigmente bzw. Füllstoffe und stabilisiert somit das Gesamtsystem.

Übliche Pastensysteme mit keramischen Füllstoffen, wie sie vor allem in der Dickschichttechnik zum Aufbau von Keramischen Sensoren eingesetzt werden, zeichnen sich dadurch aus, dass sie im Gesamtverbund mit Grünfolien ohne signifikanten Rückstand von Kohlenstoff ausbrennen, und somit die eigentliche Funktionsschicht aus den zugesetzten Pigmenten bzw. Füllstoffen zurückbleibt.

### Vorteile der Erfindung

Die erfindungsgemäße wasserlösliche Paste hat gegenüber dem Stand der Technik den Vorteil, dass eine wesentliche Reduktion der Gefährdung von Personen und Umwelt durch Verwendung umweltverträglicher, auch für den Menschen unkritischer Substanzen erreicht wird.

Insbesondere sind der wasserlöslichen Paste lediglich Stoffe zugesetzt, die auch in der Kosmetikindustrie eingesetzt werden können.

Weiter ist vorteilhaft, dass die erfindungsgemäße wasserlösliche Paste ein stabiles, robustes System ist, das unempfindlich auf geringe Chargenschwankungen der eingesetzten Füllstoffe reagiert.

Dabei ist zu berücksichtigen, dass beispielsweise die spezifische Oberfläche, die mittlere Teilchengröße und der Feuchtegehalt der bevorzugt als Pulver zugesetzten keramischen und/oder metallischen Füllstoffe maßgeblich die Eigenschaften der wasserlöslichen Paste durch Wechselwirkung mit der flüssigen Trägerphase aus Binde- und Lösungsmittel sowie gegebenenfalls Weichmacher und Dispergator beeinflusst.

In diesem Zusammenhang hat die erfindungsgemäße wasserlösliche Paste weiter den Vorteil, dass sie die Einarbeitung verschiedenster Füllstoffe und gegebenenfalls auch Farbpigmente über einen vergleichsweise weiten Bereich der spezifischen Oberfläche der eingesetzten Pulverteilchen und/oder ein vergleichsweise weiten Bereich der mittleren Teilchengröße der eingesetzten Pulverteilchen ermöglicht, wobei gleichzeitig die Kornform eine untergeordnete Rolle spielt.

Weitere Vorteile der erfindungsgemäßen wasserlöslichen Paste liegen in deren guten Verarbeitungseigenschaften auch bei vergleichsweise hohen Füllgraden bezüglich des keramischen und/oder metallischen Füllstoffes, so dass diese insbesondere auch beim Siebdruck und beim Aufbau von Keramischen Sensoren in Dickschichttechnik einsetzbar ist, und es erlaubt, sehr ebene, auch dickere Druckschichten zu erzeugen.

Schließlich eignet sich zur Reinigung von Verarbeitungsmaschinen, mit denen die erfindungsgemäße wasserlösliche Paste verarbeitet wurde, auch Wasser als Reinigungsmittel, so dass eine vereinfachte und preiswertere Entsorgung dieses Reinigungsmittels möglich ist. Somit ist die erfindungsgemäße wasserlösliche Paste auch unter dem Aspekt der Reinigung und Entsorgung umwelt- und personenfreundlich.

Vorteilhafte Weiterbildungen der Erfindung ergeben sich aus den in den Unteransprüchen genannten Maßnahmen.

So ist besonders vorteilhaft, dass in die wasserlösliche Paste metallische und/oder keramische Partikel als Füllstoff mit einer mittleren Teilchengröße im unteren Nanometer-Bereich bei gleichzeitig hohen Füllstoffgehalten von mehr als 45 Gew.%, insbesondere mehr als 55 Gew.%, einarbeitbar sind, ohne dass die Verarbeitbarkeit der Pasten nennenswert beeinträchtigt wird.

Weiter ist vorteilhaft, wenn als Binder Polyvinylpyrrolidon, vorzugsweise mit einem Molekulargewicht zwischen 700 g/mol und 1000000 g/mol, eingesetzt wird, da dieser Binder sowohl biologisch abbaubar ist als auch dispergierend wirkt, d. h. es kann bei Verwendung dieses Binders in der Regel auf den Einsatz eines zusätzlichen Dispergators verzichtet werden. Dies führt unter anderem dazu, dass auf eine vergleichsweise aufwändige Optimierung des Dispergators und Dispergatorgehaltes in der Paste hinsichtlich des jeweils eingesetzten metallischen und/oder keramischen Füllstoffes verzichtet werden kann.

Schließlich ist vorteilhaft, dass auch die in die wasserlösliche Paste eingesetzten Lösungsmittel für die Umwelt unkritisch sind und nicht gesundheitsgefährdend wirken.

Ausführungsbeispiele Ein erstes Ausführungsbeispiel für eine erfindungsgemäße wasserlösliche Paste, die als Siebdruckpaste oder allgemeiner als Druckpaste, beispielsweise bei einem Dispensverfahren oder einem Inkjet-Verfahren, insbesondere zur Herstellung oder dem Aufbau von Sensorelementen oder Bauteilen mit keramischen Druckschichten oder keramischen Schutzschichten, einsetzbar ist, geht aus von einem Lösungsmittel, einem Binder und einem Füllstoff, wobei der Binder biologisch abbaubar ist.

Als Binder wird bevorzugt Polyvinylpyrrolidon (Poly(N-vinylpyrrolidon) eingesetzt, der vorzugsweise ein Molekulargewicht zwischen 700 g/mol und 1000000 g/mol aufweist. Das der wasserlöslichen Paste zugesetzte Lösungsmittel ist beispielsweise Wasser, ein Glycol, insbesondere Ethylenglycol, Propylenglycol, Polyethylenglycol oder Polypropylenglycol, ein Diol, insbesondere 1,2-Propandiol oder 1,3-Propandiol, oder ein Blockcopolymer aus Monomereinheiten von Polyethylenglycol oder Polypropylenglycol. Es kann auch eine Mischung mit mindestens zwei dieser Lösungsmittel eingesetzt werden.

Der Füllstoff ist bevorzugt ein keramisches und/oder ein metallisches Pulver mit einer spezifischen Oberfläche im Bereich von 0,1 m²/g bis 50 m²/g, beispielsweise 5 m²/g, der mit einer mittleren Teilchengröße im Bereich von 10 nm bis 10 µm, insbesondere 20 nm bis 500 nm, eingesetzt wird. Bevorzugt ist der Füllstoff aus der Gruppe Zirkoniumdioxid, Aluminiumoxid, Titanoxid, Platin, Silber, einer Silber-Platin-Legierung oder einer Mischung mit mindestens zwei dieser Materialien ausgewählt.

Insbesondere wird der Füllstoff der wasserlöslichen Paste als Pulver in einem Anteil von 45 Gew.% bis 80 Gew.%, vorzugsweise 55 Gew.% bis 80 Gew.%, zugesetzt. Weiter kann auch vorgesehen sein, dass der Paste zusätzlich ein Farbpigment zugesetzt ist.

Schließlich ist in vielen Fällen vorteilhaft, wenn der Paste zusätzlich ein Weichmacher, insbesondere Glycerol, Polyethylenglycol oder Polypropylenglycol, zugesetzt ist. Als der Paste weiter bei Bedarf zusetzbarer Dispergator eignet sich beispielsweise Trioxadecansäure, Dynol oder Polyvinylpyrrolidon. Insofern kann der Dispergator auch mit dem bevorzugt eingesetzten Binder Polyvinylpyrrolidon identisch sein.

Im Einzelnen wird als Binder bevorzugt Polyvinylpyrrolidon der BASF AG, Ludwigshafen, mit der Handelsbezeichnung PVP K17 oder PVP K30 eingesetzt. Es eignen sich auch entsprechende Produkte der Firmen Aldrich, Dow Chemicals oder Polysciences Europe GmbH, Eppelheim.

Sofern Blockcopolymere als Lösungsmittel eingesetzt werden, werden bevorzugt Polyethylenglycol- und Polypropylenglycol-Typen der Firma BASF AG, Ludwigshafen, eingesetzt, die unter dem Handelsnamen Pluronic® PE Typen vertrieben werden.

Als Dispergator wird beispielsweise der Dispergator Dynol® 604 der Firma Air Products eingesetzt. Daneben eignen sich neben Trioxadecansäure und Polyacrylsäure auch Dispergatoren auf Grundlage von Polyvinylpyrrolidon die von der Firma BYK Chemie unter dem Handelsnamen Disperplast® vertrieben werden, beispielsweise Disperplast®-1142, oder Dispergatoren der Firma Formulation Chemicals, die unter dem Handelsnamen Duramax® D-3021 vertrieben werden.

Konkret besteht eine erste erfindungsgemäße wasserlösliche Paste beispielsweise aus 70 Gew.% Al₂O₃ der Firma Sumitomo, Japan (Handelsname: AKP 53), 8 Gew.% Polyvinylpyrrolidon der Firma BASF AG, Ludwigshafen (Handelsname: PVP K 30), 22 Gew.% 1,2-Propandiol und 1 Gew.% Trioxadecansäure.

In einem zweiten Ausführungsbeispiel besteht die erfindungsgemäße wasserlösliche Paste aus 58 Gew.% Al₂O₃ der Firma Sumitomo, Japan (Handelsname: AKP 53), aus 9 Gew.% Polyvinylpyrrolidon der Firma BASF AG, Ludwigshafen (Handelsname: PVP K 30), 32 Gew. % Polypropylenglycol und 1 Gew. % Polyacrylsäure.

In einem dritten Ausführungsbeispiel besteht die erfindungsgemäße Paste aus 47 Gew. % Al₂O₃ der Firma Sumitomo, Japan (Handelsname: AKP 53), aus 19 Gew.% Polyvinylpyrrolidon der Firma BASF AG, Ludwigshafen (Handelsname: PVP K 30), 33 Gew.% Wasser und 1 Gew.% Polyacrylsäure.

Die Herstellung der vorgenannten wasserlöslichen Pasten erfolgt mit Hilfe von handelsüblichen Herstellungsaggregaten. Dazu wird bevorzugt zunächst der Binder durch die flüssige Phase, d. h. das Lösungsmittel, aufgelöst, dieser Mischung gegebenenfalls der Weichmacher und/oder der Dispergator zugesetzt, und anschließend der Füllstoff in der Mischung dispergiert. Zur Dispergierung eignen sich beispielsweise ein Attritor, ein Dissolver oder ein Dreiwalzenstuhl.

## Patentansprüche

1. Wasserlösliche Paste, insbesondere Druckpaste, mit einem Lösungsmittel, einem Binder und einem Füllstoff, wobei der Binder biologisch abbaubar ist, und wobei der Füllstoff ein keramischer Füllstoff, ein metallischer Füllstoff oder eine Mischung aus einem keramischen und einem metallischen Füllstoff ist.

2. Wasserlösliche Paste nach Anspruch 1, **dadurch gekennzeichnet, dass** das Lösungsmittel aus der Gruppe Wasser, einem Glycol, insbesondere Ethylenglycol, Propylenglycol, Polyethylenglycol oder Polypropylenglycol, einem Diol, insbesondere 1,2-Propandiol oder 1,3-Propandiol, einem Blockcopolymer aus Monomereinheiten von Polyethylenglycol oder Polypropylenglycol, oder einer Mischung mit mindestens zwei dieser Lösungsmittel ausgewählt ist.

3. Wasserlösliche Paste nach Anspruch 1 oder 2, **dadurch gekennzeichnet, dass** der Binder Polyvinylpyrrolidon mit einem Molekulargewicht zwischen 700 g/mol und 1.000.000 g/mol ist.

4. Wasserlösliche Paste nach Anspruch 1, **dadurch gekennzeichnet, dass** der Paste ein Weichmacher, insbesondere Glycerol, Polyethylenglycol oder Polypropylenglycol, zugesetzt ist.

5. Wasserlösliche Paste nach Anspruch 1, **dadurch gekennzeichnet, dass** der Paste ein Dispergator und/oder ein als Dispergator wirkender Binder, insbesondere Trioxadecansäure, Polyvinylpyrrolidon, Polyacrylsäure oder Dynol, zugesetzt ist.

6. Wasserlösliche Paste nach einem der vorangehenden Ansprüche, **dadurch gekennzeichnet, dass** der Füllstoff als keramisches und/oder metallisches Pulver mit einer spezifischen Oberfläche im Bereich von 0,1 m²/g bis 50m²/g eingesetzt ist.

7. Wasserlösliche Paste nach einem der vorangehenden Ansprüche, **dadurch gekennzeichnet, dass** der Füllstoff als keramisches und/oder metallisches Pulver mit einer mittleren Teilchengröße im Bereich von 10 nm bis 10 µm, insbesondere 20 nm bis 500 nm, eingesetzt ist.

8. Wasserlösliche Paste nach einem der vorangehenden Ansprüche, **dadurch gekennzeichnet, dass** der Füllstoff der Paste in einem Anteil von 45 Gew.% bis 80 Gew.%, insbesondere 55 Gew.% bis 80 Gew.%, zugesetzt ist.

9. Wasserlösliche Paste nach einem der vorangehenden Ansprüche, **dadurch gekennzeichnet, dass** der Füllstoff aus der Gruppe ZrO₂, Al₂O₃, TiO₂, Pt, Ag, AgPd oder einer Mischung mit mindestens zwei dieser Materialien ausgewählt ist.

10. Wasserlösliche Paste nach Anspruch 1, **dadurch gekennzeichnet, dass** der Paste ein Farbpigment zugesetzt ist.

11. Verwendung einer wasserlöslichen Paste nach einem der vorangehenden Ansprüche als Siebdruckpaste oder als Druckpaste bei einem Dispensverfahren oder einem Inkjet-Verfahren, insbesondere zur Herstellung von Sensorelementen oder Bauteilen mit keramischen Druckschichten oder keramischen Schutzschichten.
